# EUROPEAN PATENT APPLICATION

(11) **EP 4 439 561 A1**
(43) Date of publication of application: **02.10.2024**
(21) Application number: 24167493.6
(22) Date of filing: 28.03.2024
(51) Int. Cl.: G11C 5/14, G05F 1/46, G05F 3/30, G11C 16/30

(54) **A START-UP CIRCUIT FOR BANDGAP REFERENCES IN A NAND FLASH**

(30) Priority: 29.03.2023 IN 202341023172
(71) Applicant: Samsung Electronics Co., Ltd., Suwon-si, Gyeonggi-do 16677 (KR)
(72) Inventor: SINGH, Shubham Raj, 16677 Suwon-si (KR); THAKUR, Arvind, 16677 Suwon-si (KR); TAIGOR, Subodh Prakash, 16677 Suwon-si (KR)
(74) Representative: Marks & Clerk LLP

(57) **Abstract**

Various example embodiments relate to a capacitor action-based start-up circuit for bandgap reference (BGR) generation. The start-up circuit comprises a start-up capacitor (C_ST) connected to a VBG node of a BGR sub-circuit. The start-up capacitor (C_ST) determines if a state of operation of the BGR sub-block is one of normal, and failure. The start-up circuit comprises an output transistor (M0) connected to an NB node of the BGR. The output transistor (M0) charges the NB node to maintain normal operation of the BGR sub-block, if the state of operation of the BGR sub-block is failure, thereby facilitating dynamic behavior.

## Description

### BACKGROUND

Various example embodiments disclosed herein relate to NAND flash devices, systems including the NAND flash devices, and/or methods of operating the NAND flash devices, and more particularly to start-up circuits for bandgap references in NAND flash devices, etc.

Start-up circuits in NAND flash memory devices play a crucial role in achieving specific operational characteristics, such as, but not limited to, zero steady-state current, wide supply range operation, and dynamic behavior. For example, in a smartphone, power efficiency and flexibility are desired and these characteristics (e.g., zero steady-state current, wide supply range operation, and dynamic behavior) are desired and/or important for efficient and reliable performance. Start-up circuits are designed to decrease, minimize, and/or eliminate steady-state current draw when the NAND flash device is in a standby mode and/or idle mode. These circuits control the initialization sequence so that undesired and/or unnecessary power consumption is decreased and/or avoided when the memory is not actively performing read and/or write operations. Start-up circuits incorporate voltage regulators and/or converters so that the NAND flash memory operates reliably even with varying input voltages. Start-up circuits have to dynamically adjust reference voltages and currents during various operations of the NAND flash memory device.

Hence, there is a desire for NAND flash memory devices which overcome the above-mentioned drawback(s), among others.

Various example embodiments of the inventive concepts disclose a start-up circuit in bandgap references for NAND flash devices, systems including the NAND flash devices, and/or methods of operating the NAND flash devices, and more particularly to a start-up circuit in bandgap references with zero steady state current, dynamic behavior, and a wide supply range of operation.

### SUMMARY

Accordingly, some example embodiments herein provide a capacitor action-based start-up circuit for bandgap reference (BGR) generation. The start-up circuit comprises a start-up capacitor (C_ST) connected to a VBG node of a BGR sub-block, wherein the start-up capacitor (C_ST) determines if a state of operation of the BGR sub-block is one of normal, and failure. The start-up circuit comprises an output transistor (M0) connected to an NB node of the BGR, wherein the output transistor (M0) charges the NB node to maintain normal operation of the BGR sub-block, if the state of operation of the BGR sub-block is failure, thereby facilitating dynamic behavior.

According to an embodiment there is provided a capacitor action-based start-up circuit for bandgap reference (BGR) generation, comprising: a start-up capacitor connected to a bandgap voltage (VBG) node of a BGR sub-circuit, the start-up capacitor configured to determine whether an operating state of the BGR sub-circuit is in a normal state or a failure state; and an output transistor connected to a desired node (e.g. a first node) of the BGR sub-circuit, the output transistor is configured to charge the slowest node to change the operating state of the BGR sub-circuit to the normal state, in response to the operating state of the BGR sub-circuit being the failure state.

A BGR sub-circuit may be configured to generate a bandgap reference voltage based on a bandgap of one or more transistors of the BGR sub-circuit. A normal state may be a functioning state in which the bandgap reference voltage is generated. A failure state may be a state in which the bandgap reference voltage is not generated. The bandgap reference voltage may be applied to the bandgap voltage node. The BGR sub-circuit may be configured to output the bandgap voltage from the bandgap voltage node. The desired node may be a slowest node of the BGR sub-circuit. The slowest node of the BGR sub-circuit may be a node that has a largest time constant (e.g. the dominant pole of the BGR sub-circuit).

According to an embodiment, the output transistor is further configured to: turn off while the operating state of the BGR sub-circuit is in the normal state; and charge the desired node of the BGR sub-circuit in response to the operating state of the BGR sub-circuit being in the failure state. For instance, the output transistor may have a gate connected to the start-up capacitor. The start-up capacitor may maintain a voltage differential between a top plate and a bottom plate in response to the operating state of the BGR sub-circuit being the failure state. The voltage differential may activate the output transistor (e.g. through application of an activation voltage to a gate of the output transistor).

At least some of the above and other features of the invention are set out in the claims.

These and other aspects of the example embodiments herein will be better appreciated and understood when considered in conjunction with the following description and the accompanying drawings. It should be understood, however, that the following descriptions, while indicating several example embodiments and numerous specific details thereof, are given by way of illustration and not of limitation. Many changes and modifications may be made within the scope of the example embodiments herein without departing from the scope thereof, and the example embodiments herein include all such modifications.

These and other aspects of the example embodiments of the inventive concepts will be better appreciated and understood when considered in conjunction with the following description and the accompanying drawings. It should be understood, however, that the following descriptions, while indicating at least one example embodiment of the inventive concepts and numerous specific details thereof, are given by way of illustration and not of limitation. Many changes and modifications may be made within the scope of the example embodiments herein without departing from the scope thereof, and the example embodiments herein include all such modifications.

### BRIEF DESCRIPTION OF FIGURES

Various example embodiments herein are illustrated in the accompanying drawings, throughout which like reference letters indicate corresponding parts in the various figures. The example embodiments herein will be better understood from the following description with reference to the following drawings. Various example embodiments herein are illustrated by way of examples in the accompanying drawings, and in which:
FIG. 1A illustrates a BGR circuit;
FIG. 1B illustrates a graphical representation of different node voltages of the BGR circuit, according to the conventional art;
FIG. 2 illustrates bandgap reference (BGR) with Start-up circuit block, according to the conventional art;
FIG. 3 illustrates a block diagram representing the system 300 for bandgap reference (BGR) generation using a capacitor action-based start-up circuit, according to at least one example embodiment;
FIG. 4 illustrates an example schematic of the start-up circuit with the BGR sub-block according to at least one example embodiment;
FIG. 5 shows an example schematic representation of the start-up circuit with the auxiliary network, according to at least one example embodiment;
FIGs. 6A and 6B depict the results of the tests of the start-up circuit, according to at least one example embodiment;
FIG. 7A illustrates the digital circuit for addressing initially charged start-up capacitor, according to at least one example embodiment; and
FIG. 7B depicts the variations of different outputs in the start-up circuit with the BGR sub-block, according to at least one example embodiment.

### DETAILED DESCRIPTION

Various example embodiments of the inventive concepts and the various features and advantageous details thereof are explained more fully with reference to the non-limiting example embodiments that are illustrated in the accompanying drawings and detailed in the following description. Descriptions of well-known components and processing techniques are omitted so as to not unnecessarily obscure the one or more example embodiments of the inventive concepts described herein. The examples used herein are intended merely to facilitate an understanding of ways in which the example embodiments so that they may be practiced and to further enable those of ordinary skill in the art to practice the example embodiments herein. Accordingly, the examples should not be construed as limiting the scope of the example embodiments.

For the purposes of interpreting this specification, the definitions (as defined herein) will apply and whenever appropriate the terms used in singular will also include the plural and vice versa. It is to be understood that the terminology used herein is for the purposes of describing particular example embodiments only and are not intended to be limiting. The terms "comprising", "having" and "including" are to be construed as open-ended terms unless otherwise noted.

The words/phrases "exemplary", "example", "illustration", "in an instance", "and the like", "and so on", "etc.", "etcetera", "e.g.," , "i.e.," are merely used herein to mean "serving as an example, instance, or illustration." Any example embodiment or implementation of the present subject matter described herein using the words/phrases "exemplary", "example", "illustration", "in an instance", "and the like", "and so on", "etc.", "etcetera", "e.g.," , "i.e.," is not necessarily to be construed as preferred or advantageous over other example embodiments.

Various example embodiments of the inventive concepts may be described and illustrated in terms of blocks which carry out a described function or functions. These blocks, which may be referred to herein as managers, units, modules, hardware components or the like, are physically implemented by analog and/or digital circuits such as logic gates, integrated circuits, microprocessors, microcontrollers, memory circuits, passive electronic components, active electronic components, optical components, hardwired circuits and the like, and may optionally be driven by a firmware. The circuits may, for example, be embodied in one or more semiconductor chips, or on substrate supports such as printed circuit boards and the like. The circuits comprising a block may be implemented by dedicated hardware, or by a processor (e.g., one or more programmed microprocessors and associated circuitry), or by a combination of dedicated hardware to perform some functions of the block and a processor to perform other functions of the block. Each block of the example embodiments may be physically separated into two or more interacting and discrete blocks without departing from the scope of the example embodiments of the inventive concepts. Likewise, the blocks of the example embodiments may be physically combined into more complex blocks without departing from the scope of the example embodiments of the inventive concepts.

It should be noted that elements in the drawings are illustrated for the purposes of this description and ease of understanding and may not have necessarily been drawn to scale. For example, the flowcharts/sequence diagrams illustrate the method in terms of the operations disclosed for understanding of aspects of the example embodiments of the inventive concepts. Furthermore, in terms of the construction of the device, one or more components of the device may have been represented in the drawings by conventional symbols, and the drawings may show only those specific details that are pertinent to understanding the example embodiments so as not to obscure the drawings with details that will be readily apparent to those of ordinary skill in the art having the benefit of the description herein. Furthermore, in terms of the system, one or more components/modules which comprise the system may have been represented in the drawings by conventional symbols, and the drawings may show only those specific details that are pertinent to understanding the example embodiments so as not to obscure the drawings with details that will be readily apparent to those of ordinary skill in the art having the benefit of the description herein.

The accompanying drawings are used to help easily understand various technical features and it should be understood that the example embodiments presented herein are not limited by the accompanying drawings. As such, the example embodiments of the inventive concepts should be construed to extend to any modifications, equivalents, and/or substitutes in addition to those which are particularly set out in the accompanying drawings and the corresponding description. Usage of words such as first, second, third etc., to describe components/elements/steps is for the purposes of this description and should not be construed as sequential ordering/placement/occurrence unless specified otherwise.

Various example embodiments herein achieve a start-up circuit in bandgap reference for NAND flash memory, with zero steady state current, dynamic behavior, and a wide supply range of operation. Referring now to the drawings, where similar reference characters denote corresponding features consistently throughout the figures, there are shown one or more example embodiments of the inventive concepts.

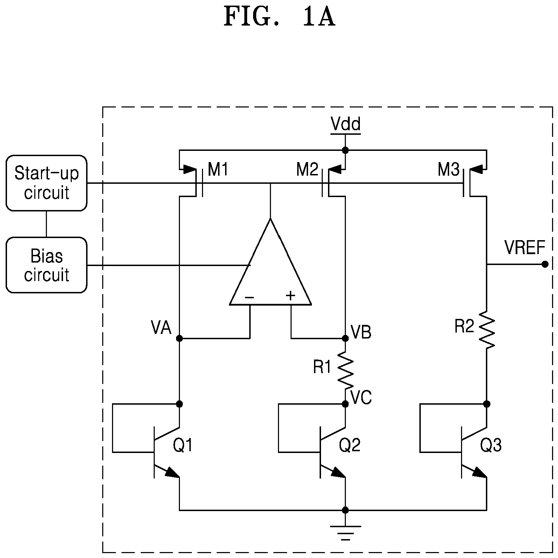

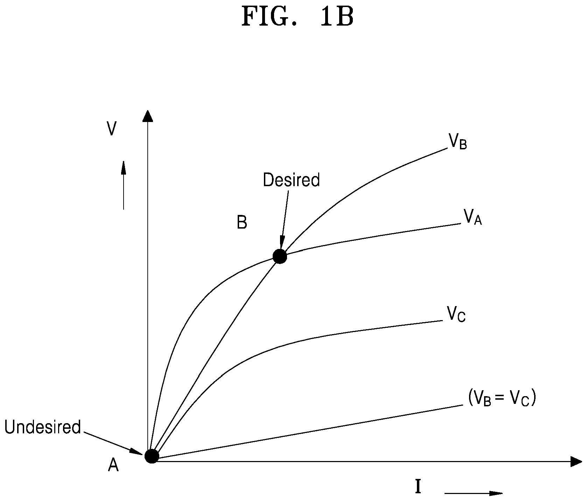

FIG. 1A illustrates a GBR circuit. FIG. 1B illustrates a graphical representation of different node voltages of the bandgap reference (BGR) circuit, according to the conventional art. As shown in FIG. 1B, the two intersection points A and B of voltages VA and VB (as shown in FIG. 1A) are the stable points of the BGR core circuit. At position A, the currents I1 and I2 that flow in the BGR core circuit are undesirably small and equal, which causes the output of the BGR circuit to be low and the output of the operational amplifier OP-AMP of FIG. 1A to be near a power supply voltage V_{DD}. At position B, identical currents of desired values flow in the BGR core circuit which enables the circuit to work properly. In order to ensure proper operation of the BGR core circuit, the operation at position B (as shown in FIG. 1B), is desired and may be achieved by using a start-up circuit.

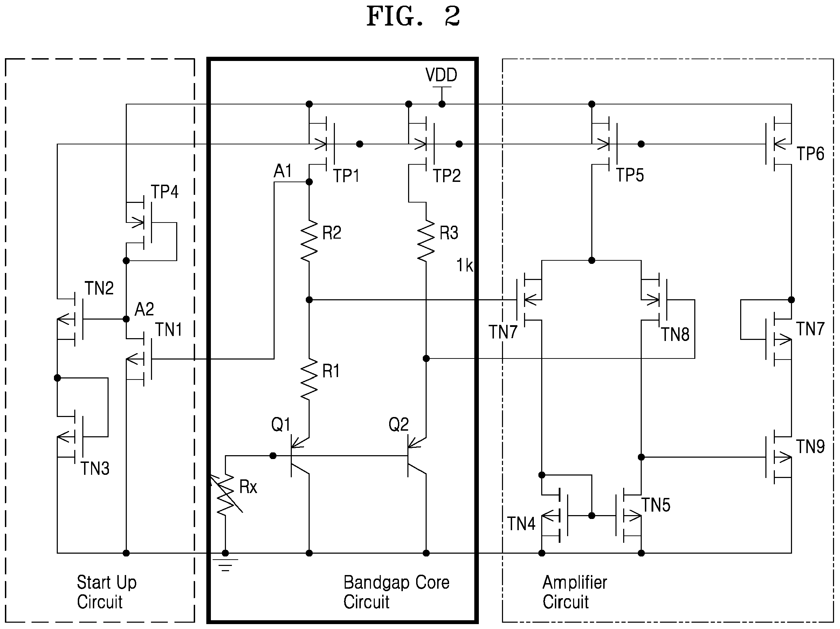

FIG. 2 illustrates a bandgap reference (BGR) with a start-up circuit block, according to the conventional art. As shown in FIG. 2, the start-up circuit comprises a plurality of transistors, e.g., transistors TN1, TN2, TN3, and TP4. TN1, TN2 and TN3 are n-doped transistors (e.g. n-doped MOSFETS) and TP4 is a p-doped transistor (e.g. a p-doped MOSFET). The voltage at the gate of TN1 is low when the core BGR circuit is in a zero current state. The transistor TP4, which is diode connected, is always ON, and therefore, the transistor TN2 turns ON forcing the drain to a low value. Due to this, the gate, e.g., node A1, of TN1 rises and starts to conduct. Once the BGR core circuit starts working properly, the transistor TN1 starts to conduct and lowers the voltage potential of node A2, which causes the start-up circuit to stop operating and disconnects from the BGR core circuit. The start-up circuit may be used for a wide voltage supply range and may inefficiently and/or unnecessarily consume static power due to transistors TP4 and TN1. These transistors will be in the ON state even when the BGR core circuit starts operating properly and the start-up circuit detaches itself from the BGR core circuit. In response to the BGR core circuit being stuck in the zero current state, the start-up circuit senses the zero current state through the nodes A1 and A2, and begins operating, which illustrates that the start-up circuit is dynamic in nature. Due to the above deficiencies of conventional BGR circuits and/or start-up circuits, it is desired that start-up circuits in BGR circuits should have the following desirable features, e.g., zero steady state current, wide voltage supply range operation, and/or dynamic behavior, etc. However, the conventional start-up circuits do not possess all of these features and/or do not provide all of these features simultaneously.

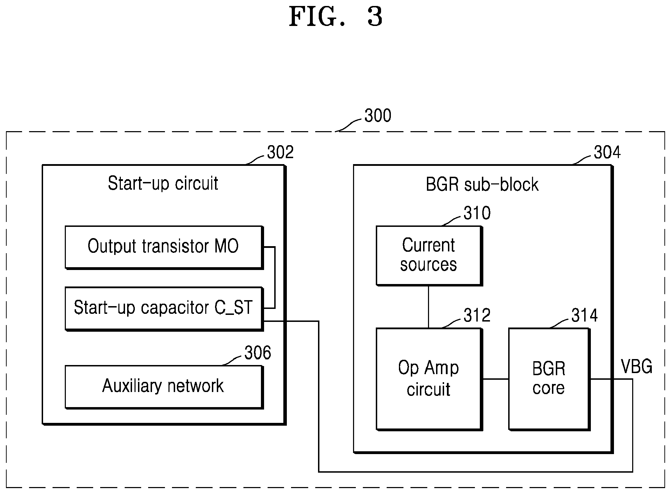

FIG. 3 illustrates a block diagram representing a system 300 for bandgap reference (BGR) generation using a capacitor action-based start-up circuit, according to at least one example embodiment of the inventive concepts. The system 300 comprises a start-up circuit 302 connected to a Bandgap Reference (BGR) circuit 304 (e.g., a BGR sub-block, BGR sub-circuit, etc.). The start-up circuit 302, according to at least one example embodiment, comprises an output transistor M0 and a capacitor (C_ST), but is not limited thereto. The output transistor M0 serves as a switch to control the flow of current during a failure state and/or failure condition of the BGR circuit 304. The start-up capacitor C_ST may control a dynamic behavior of the start-up circuit 302. The start-up circuit 302 may further include at least one diode (not shown), and the diode may be connected within the start-up circuit 302 to decrease and/or prevent a reverse current from flowing within the start-up circuit 302, but the example embodiments are not limited thereto. The start-up circuit 302 may further include an auxiliary network 306 for controlling a timing of the activation of the start-up circuit. Further, the start-up circuit 302 may further include a fail-safe mechanism (not shown in the figures) to protect the auxiliary network from false charging during bias circuit failures, and/or to protect the auxiliary network during power up of the BGR sub-block 304, etc. The bandgap sub-block 304 comprises an operational amplifier (Op-Amp) 312 (e.g. Op-Amp circuit 312) connected to one or more current sources 310, and a BGR core 314, e.g., BGR core circuit 314, etc., but the example embodiments are not limited thereto. The BGR core 314 may provide a desired reference voltage (e.g., a bandgap reference voltage) at a node VBG.

A bottom plate of the start-up capacitor C_ST may be connected to a VBG node of the BGR sub-block 304. During normal operation of the BGR sub-block 304 and when the start-up circuit 302 is OFF, a top plate of the start-up capacitor C_ST is charged to a difference between a power supply voltage VDD and a diode threshold voltage VTH_{Diode}, e.g., VDD-VTH_{Diode}, and the bottom plate is charged to the voltage of the node VBG. VTH_{Diode} is the threshold voltage of a diode (e.g. a diode connected to the top plate, e.g. between a power supply and the top plate). The threshold voltage is the voltage at which a diode begins to conduct current. VDD is the supply voltage that is supplied to the start-up circuit 302 as well as the BGR sub-block 304 and the BGR core 314. During a failure condition of the BGR sub-block 304, the voltage of the node VBG drops by a voltage differential ΔV between the voltage at the bottom plate of the start-up capacitor C_ST and the top plate of the start-up capacitor. The voltage drop in the voltage of the node VBG activates an output transistor M0 causing the output transistor M0 to switch ON and charge the slowest node, e.g., node NB, in the BGR sub-block 304 to maintain normal operation of the BGR sub-block 304, thereby facilitating dynamic behavior. The slowest node in the BGR sub-block 304 is determined on the basis of a dominant pole. Pole occurs at the nodes of the circuit and its location depends on the value of resistance (R) and capacitance (C) at that particular node. The node having the highest value of R and C gives the dominant pole. Therefore, the dominant pole has the largest time constant and hence gives the slowest node of the circuit. The node having the dominant pole is the slowest node in the BGR sub-block 304. During the failure state (e.g., failure condition, etc.) of the BGR sub-block 304, the switching ON of the start-up circuit supplies current to a slowest node NB in the BGR core 314, and then current flows in the operational amplifier Op Amp 312, which works in a negative feedback loop, thereby stabilizing the voltage of the node VBG.

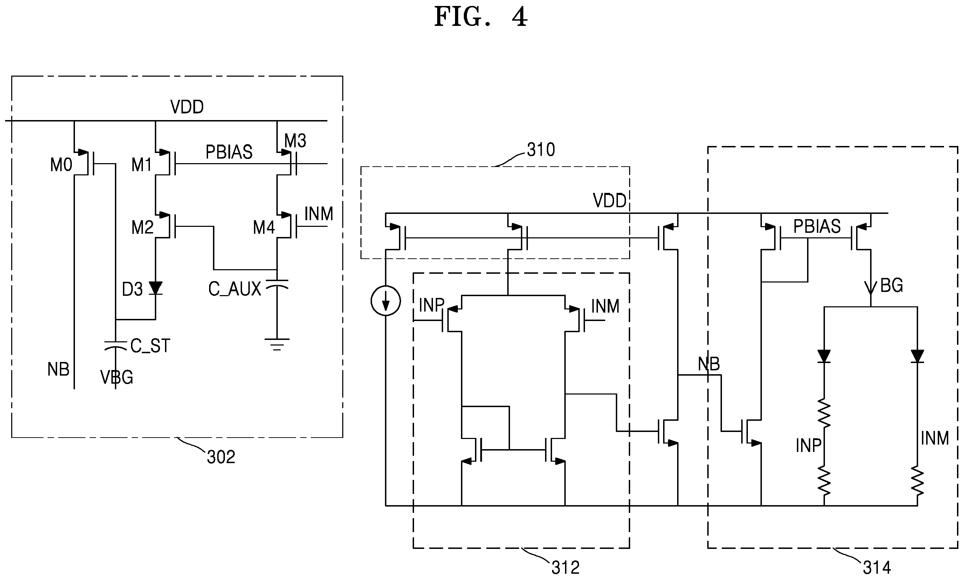

FIG. 4 illustrates an example schematic of the start-up circuit 302 with the BGR sub-block 304, according to at least one example embodiment. However, it is to be noted that the topology of the start-up circuit and the BGR sub-block of the example embodiments of the inventive concepts are not limited to the one or more example embodiments illustrated in FIG. 4. According to at least one example embodiment, a start-up circuit 302 comprises the output transistor M0 which is connected to the slowest node NB of a BGR sub-block 304 (e.g., BGR circuit, BGR sub-circuit, etc.), but is not limited thereto. A start-up capacitor C_ST is connected to a VBG node of the BGR sub-block 304, wherein the start-up capacitor C_ST determines whether a state of operation of the BGR sub-block 304 is one of a normal state (e.g., normal condition, etc.) and/or a failure state (e.g., failure condition, etc.).

The start-up capacitor C_ST comprises a top plate and a bottom plate. The bottom plate is connected to the VBG node of the BGR sub-block 304. The top plate is connected to the gate of the output transistor M0. The top plate is also connected to a diode D3. The diode is connected between a power supply voltage VDD and the top plate.

The output transistor M0 charges the NB node to maintain normal operation of the BGR sub-block 304, if the state of operation of the BGR sub-block 304 is the failure state, thereby facilitating, enabling, and/or improving dynamic behavior. The output transistor M0 is turned off during the normal operation of a BG core circuitry 314 (e.g., when the BGR sub-block 304 is in the normal state), and the output transistor M0 charges the NB node of the BGR sub-block 304 when the BGR sub-block 304 is in the failure state. The normal state may be a non-failure state. When the BGR sub-block 304 is in the normal state, the top plate of the start-up capacitor C_ST is charged to a difference between the power supply voltage VDD and a diode threshold voltage VTHDiode (a threshold voltage of the diode D3). That is, the voltage at the top plate is equal to VDD-VTH_{Diode}. The bottom plate of the start-up capacitor C_ST is charged to the voltage of the node VBG. The start-up circuit 302 is in an OFF condition (e.g., the start-up circuit 302 is turned OFF and/or is in the off state, etc.) and the output transistor M0 is turned off (e.g., is in the OFF state, OFF condition, etc.) during the normal state of the BGR sub-block 304. In the failure state of the BGR sub-block 304, the output transistor M0 switches on when the top plate of the start-up capacitor C_ST is charged to VDD-VTH_{Diode}- ΔV and the bottom plate of the start-up capacitor C_ST is charged to VBG-ΔV. ΔV is the voltage difference between the voltage at the bottom plate of the start-up capacitor C_ST and voltage at the top plate of the start-up capacitor. Table 1 depicts the condition and state of the start-up circuit 302.

**Table 1**

| Condition | Top Plate of C_ST (Voltage) | Bottom plate of C_ST (Voltage) | Start-up Circuit |
|---|---|---|---|
| Normal Operation | VDD - VTH | VBG | OFF |
| Failure | VDD - VTH - ΔV | VBG - ΔV | ON |

When the start-up circuit 302 is in the ON condition (e.g., the start-up circuit 302 is turned on, etc.), the start-up circuit 302 is configured to improve and/or ensure that the condition of a memory node when the start-up circuit is in a desired and/or optimal state. The condition of the desired and/or optimal state of the memory technology node is the absolute value of a desired threshold voltage of a MOSFET being greater than the diode threshold voltage VTH_{Diode}, e.g., |VTHMOS | > VTH_{Diode}. This memory technology node refers to a specific semiconductor manufacturing process and its design rules. The MOSFET is referred to each individual MOS transistor in FIG. 4. VTHMOS refers to a threshold voltage of a MOSFET in a circuit. For example, the bottom plate of the start-up capacitor C_ST may transition from, e.g., 1.2V in the normal state of the BGR sub-block 304 to a desired diode voltage VTH_{Diode} during the failure state of the BGR sub-block 304, wherein the diode voltage VTH_{Diode} varies in, e.g., the range from 0.5V to 0.7V, but is not limited thereto. VTH_{Diode} refers to the voltage drop that occurs across the diode in the circuit. The voltage drop is due to an internal phenomenon that occurs in the depletion region in the diodes formed by the P-N junction under the influence of an applied voltage. The start-up circuit 302 comprises a diode D3. The diode D3 may decrease and/or ensure zero reverse current, wherein an auxiliary transistor M2 is switched off upon the start-up circuit 302 starting (e.g., being turned on) by the auxiliary network 306. The top plate of the start-up capacitor C_ST may charge to VDD - VTH_{Diode} only once the start-up circuit 302 starts operation (e.g., is turned on).

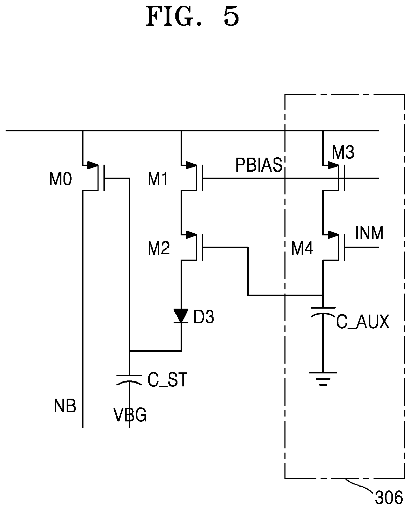

The capacitor action-based start-up circuit 300 comprises an auxiliary network 306 for controlling one of activation and deactivation of an auxiliary transistor M2 to control the timing of the start-up circuit 302 activation. FIG. 5 shows an example schematic representation of the start-up circuit 302 with the auxiliary network 306, according to at least one example embodiment. The capacitor action-based start-up circuit 302 comprises a failsafe mechanism. The failsafe mechanism includes a failsafe transistor M4 configured to protect the auxiliary network 306 from false charging during scenarios and/or conditions such as, but not limited to, failure conditions like PBIAS = 0, etc., when powering up the BGR sub-block 304, and so on. PBIAS is the node name, which is used to specify the gate voltage of PMOS transistors in the BGR core 314. PBIAS is further connected to PMOS transistors M1 and M3 in the start-up circuit 302. The auxiliary network 306 is configured to delay deactivation of the auxiliary transistor M2 to facilitate a proper charging of the start-up capacitor C_ST to the VDD-VTH_{Diode} voltage and increasing the probability and/or ensuring that there is no further leakage in a forward path to the start-up capacitor C_ST.

The start-up circuit comprises first and second transistors M1 and M2 connected in series between the power supply voltage VDD and the diode D3. The gate of M1 is connected to PBIAS. The gate of M2 is connected between the failsafe transistor M4 and an auxiliary capacitor C_AUX of the auxiliary circuit 306. The auxiliary circuit 306 includes a third transistor M3 and the failsafe transistor M4 connected in series between the power supply voltage VDD and the auxiliary capacitor C_AUX. A gate of the third transistor M3 is connected to PBIAS. A gate of the failsafe transistor is connected to INM. INM is the name of the inverting input terminal (i.e gate of a MOSFET) of the Op- Amp circuit 312. This INM node is connected to other terminals in sub-circuit BGR core (314) and Start-up circuit 302.

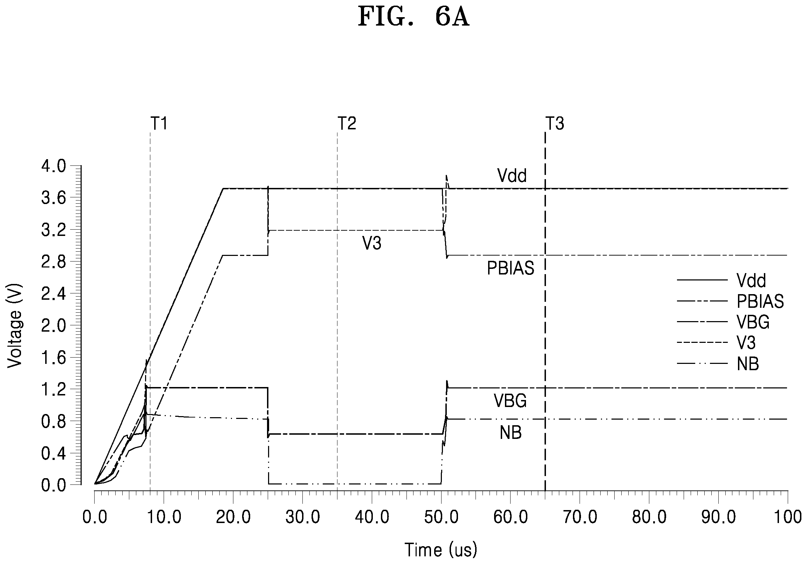

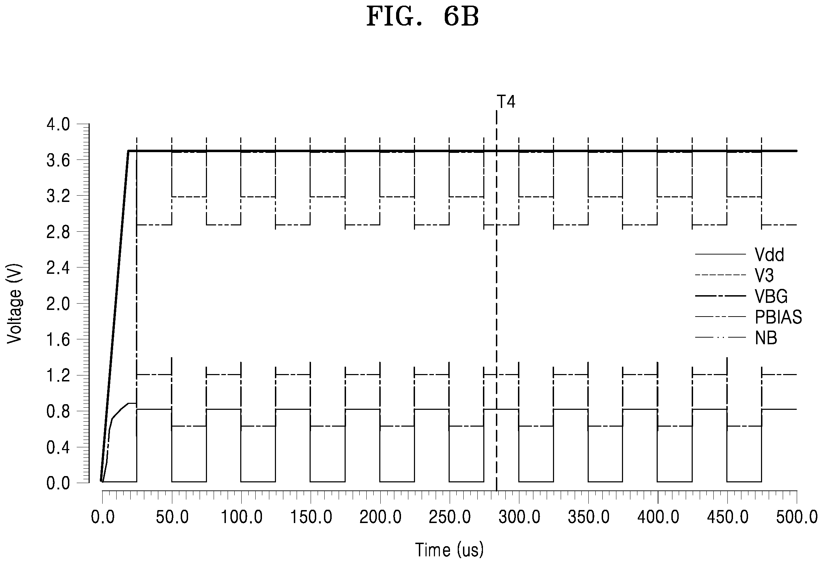

FIGs. 6A and 6B depict the results of the tests of the start-up circuit 302, according to at least one example embodiment. T1, T2 and T3 are the labels at different time instants (8µs, 35µs, and 65µs, respectively in FIG. 6A). Out of these three levels only T3 label is highlighted which gives the value of different waveforms at particular time instant at 65µs. In FIGs. 6A and 6B, I_{START-UP} is not drawn but the voltage of the slowest node NB is drawn. This NB voltage depends upon the START-UP current during the start-up action and reaches the appropriate value, which further helps to maintain the correct value of VBG. These tests have been carried out under the following test conditions: an ideal switch network is used to discharge the slowest node NB in the circuit. When the switch is removed, it is expected that the start-up circuit 302 brings the circuit back to normal operating condition, thereby confirming dynamic behavior of the start-up circuit 302. This dynamic behavior is verified for 10 cycles. Table 2 shows the test conditions and I_{START-UP}.
VDD: 1.7V and 3.7V, PVT
TEMP: -50C, 27C, 135C.

**Table 2**

| Condition | I_{START-UP} (Steady state) |
|---|---|
| VDD: 1.7V, 3.7V; PVT | < 20pA |

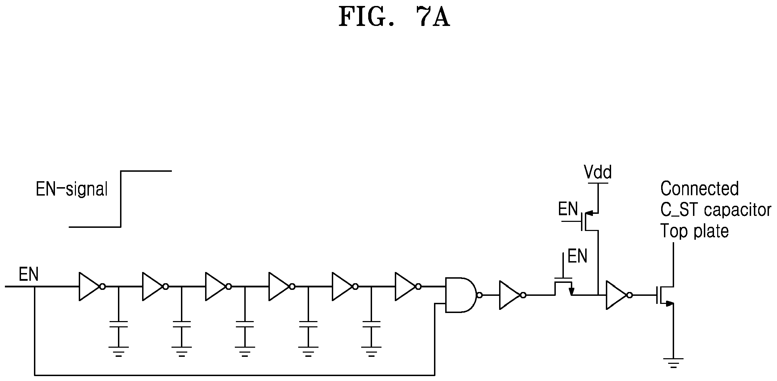

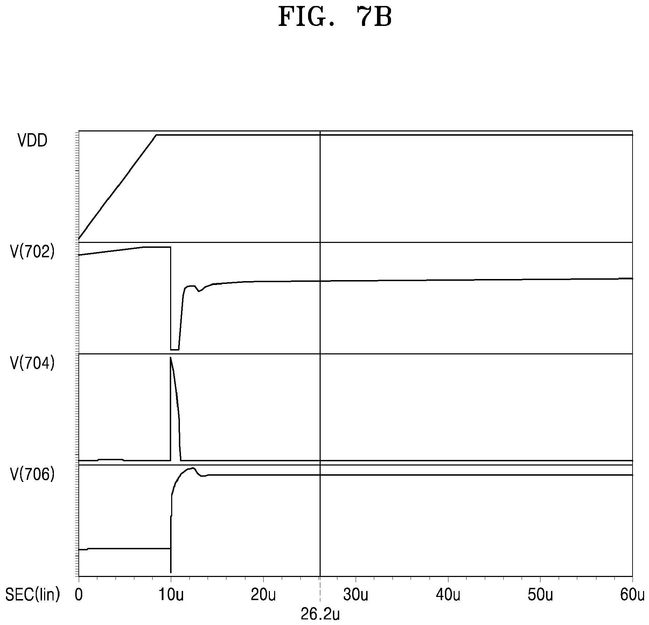

FIG. 7A illustrates the digital circuit for addressing initially charged start-up capacitor C_ST, according to at least one example embodiment. The digital circuit 700 is implemented for decreasing the probability of and/or preventing a failure scenario where the top plate of capacitor C_ST is initially at VDD. The digital circuit 700 is configured to rapidly discharge the top plate of capacitor C_ST from VDD to ground within a short timeframe when the Bandgap Reference (BGR) voltage reaches its final stabilized value. This discharge mechanism improves and/or ensures the BGR voltage output is correctly initialized and avoids and/or decreases undesired conditions associated with an elevated voltage on the capacitor's top plate during the startup phase. In FIG. 7A, the circuit is designed to generate a pulse which is used to trigger the NMOS transistor whose drain is connected to the top plate of capacitor C_ST. The En-signal is used in the circuit, which is going to the two inputs of the NAND gate, by two ways, one is directly and other is by passing through combination of six inverters, which acts as a buffer to provide the delay in EN-signal. Then the NAND, two inverters and NMOS & PMOS switches are used to generate the pulse, which is high only for the delayed time instant. The high value of the pulse is used to trigger (ON) the NMOS transistor, which rapidly discharge the top plate of capacitor C_ST from VDD to ground within a short timeframe when the Bandgap Reference (BGR) voltage reaches its final stabilized value. FIG. 7B depicts the variations of different outputs, e.g., BGR voltage output 706, start-up capacitor voltage 702, and digital pulse generation 704 to discharge start-up capacitor, according to some example embodiments herein.

Various example embodiments of the inventive concept are directed to one or more solutions suitable for technology nodes which have transistors with high voltage thresholds, e.g., VTH >0.8V, but are not limited thereto. At least one example embodiment improves and/or ensures zero steady state current in start-ups, wide supply range operation and dynamic, wherein dynamic refers to solutions capable of bringing back the VBG voltage to its normal operating value, e.g., the bandgap reference voltage, in case of any failure conditions.

One or more example embodiments disclosed herein describe a capacitor action-based start-up circuit for BGR generation. Therefore, it is understood that the example embodiments may include a non-transitory computer readable media, such as a non-transitory computer readable storage media containing program code (e.g., software programs, computer readable instructions, etc.) for implementation of one or more operations of a method for operating the capacitor action-based start-up circuit for BGR generation. The software program may be executed on a computing device, such as a server, a mobile device, or any suitable programmable computing device. The method is implemented in at least one example embodiment through or together with a software program written in, e.g., Very high-speed integrated circuit Hardware Description Language (VHDL), or another programming language, or implemented by one or more VHDL or several software modules being executed on at least one hardware device. The hardware device can be any kind of device that may be programmed. The hardware device may also include processing circuitry which may include hardware or hardware circuit including logic circuits; a hardware/software combination such as a processor executing software and/or firmware; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc., but is not limited thereto.

Embodiments are set out in the following clauses:
Clause 1. A capacitor action-based start-up circuit for bandgap reference (BGR) generation, comprising:
   a start-up capacitor connected to a bandgap voltage (VBG) node of a BGR sub-circuit, the start-up capacitor configured to determine whether an operating state of the BGR sub-circuit is in a normal state or a failure state; and
   an output transistor connected to a desired node of the BGR sub-circuit, the output transistor is configured to charge the slowest node to change the operating state of the BGR sub-circuit to the normal state, in response to the operating state of the BGR sub-circuit being the failure state.
Clause 2. The start-up circuit of clause 1, wherein the desired node is the slowest node of the BGR sub-circuit.
Clause 3. The start-up circuit of clause 1 or clause 2, wherein the output transistor is further configured to:
   turn off while the operating state of the BGR sub-circuit is in the normal state; and
   charge the desired node of the BGR sub-circuit in response to the operating state of the BGR sub-circuit being in the failure state.
Clause 4. The start-up circuit of any preceding clause, wherein the start-up capacitor is further configured to:
   maintain a voltage differential between a top plate and a bottom plate of the start-up capacitor in response to the operating state of the BGR sub-circuit being the failure state, wherein the voltage differential facilitates activation of the output transistor .
Clause 5. The start-up circuit of clause 4, wherein in response to the operating state of the BGR sub-circuit being the normal state:
   the top plate of the start-up capacitor is configured to be charged to VDD-VTH_{Diode};
   the bottom plate of the start-up capacitor is configured to be charged to a voltage of the VBG node;
   the start-up circuit is configured to be in an OFF state; and
   the output transistor is configured to be turned off.
Clause 6. The start-up circuit of clause 4 or clause 5, wherein, in response to the operating state of the BGR sub-circuit being the failure state:
   the output transistor is further configured to be switched on in response to the top plate of the start-up capacitor being charged to VDD-VTH_{Diode}- the voltage differential;
   the bottom plate of the start-up capacitor is further configured to be charged to a difference between a voltage of the VBG node and the voltage differential; and
   the start-up circuit is further configured to be turned on and change a condition of a memory node to be | VTHMOS | > VTH_{Diode}.
Clause 7. The start-up circuit of any of clauses 4-6, wherein the bottom plate of the start-up capacitor is further configured to:
   transition from 1.2V in response to the operating state of the BGR sub-circuit being the normal state, to VTH_{Diode} in response to the operating state of the BGR sub-circuit being the failure state, wherein the VTH_{Diode} varies between 0.5V to 0.7V.
Clause 8. The start-up circuit of any preceding clause, wherein the capacitor action-based start-up circuit further comprises:
   an auxiliary network including an auxiliary transistor, the auxiliary network configured to control activation and deactivation of the start-up circuit; and
   the auxiliary transistor configured to control a timing of the start-up circuit activation.
Clause 9. The start-up circuit of clause 8, wherein the capacitor action-based start-up circuit further comprises:
   a failsafe mechanism including a failsafe transistor, the failsafe mechanism configured to protect the auxiliary network from false charging during one or more failure conditions while the BGR sub-circuit is powering up.
Clause 10. The start-up circuit of clause 8 or clause 9, wherein the auxiliary network is further configured to:
   delay deactivation of the auxiliary transistor to facilitate a proper charging of the start-up capacitor to VDD-VTH_{Diode} voltage.
Clause 11. The start-up circuit of any preceding clause, wherein an operating state of the start-up circuit is determined by a voltage of the VBG node of the BGR sub-circuit.
Clause 12. The start-up circuit of any preceding clause, wherein, the start-up circuit comprises:
   a diode, the diode configured to decrease a probability of zero reverse current;
   an auxiliary transistor configured to be switched off in response to the start-up circuit being activated; and
   a top plate of the start-up capacitor is configured to charge to VDD - VTH_{Diode} a single time in response to the start-up circuit being activated.
Clause 13. A system, comprising:
   A bandgap reference (BGR) sub-circuit; and
   a capacitor action-based start-up circuit for BGR generation, wherein the start-up circuit comprises
      a start-up capacitor connected to a bandgap voltage (VBG) node of the BGR sub-circuit, the start-up capacitor configured to determine whether an operating state of the BGR sub-circuit is in a normal state or a failure state; and
      an output transistor connected to a desired node of the BGR sub-circuit, the output transistor is configured to charge the slowest node to change the operating state of the BGR sub-circuit to the normal state, in response to the operating state of the BGR sub-circuit being the failure state.
Clause 14. The system of clause 13, wherein the desired node is the slowest node of the BGR sub-circuit.
Clause 15. The system of clause 13 or clause 14, wherein the output transistor is further configured to:
   turn off while the operating state of the BGR sub-circuit is in the normal state; and
   charge the desired node of the BGR sub-circuit in response to the operating state of the BGR sub-circuit being in the failure state.

Various example embodiments described herein could be implemented using hardware or a combination of hardware and software. Additionally, or alternatively, one or more example embodiments may be implemented on different and/or several hardware devices, e.g., using processing circuitry, a plurality of CPUs, etc. The foregoing description of specific example embodiments will so fully reveal the general nature of the example embodiments of the inventive concepts that persons of ordinary skill in the art may, by applying ordinary knowledge, readily modify and/or adapt for various applications of the one or more example embodiments without departing from the inventive concepts, and, therefore, such adaptations and modifications should and are intended to be comprehended within the meaning and range of equivalents of the disclosed example embodiments of the inventive concepts. It is to be understood that the phraseology or terminology employed herein is for the purpose of description and not of limitation. Therefore, while various example embodiments of the inventive concepts have been described, those of ordinary skill in the art will recognize that the example embodiments disclosed herein may be practiced with modification within the scope of the inventive concepts.

## Claims

1. A capacitor action-based start-up circuit for bandgap reference, BGR, generation, comprising:
a start-up capacitor connected to a bandgap voltage, VBG, node of a BGR sub-circuit, the start-up capacitor configured to determine whether an operating state of the BGR sub-circuit is in a normal state or a failure state; and
an output transistor connected to a desired node of the BGR sub-circuit, the output transistor is configured to charge a slowest node to change the operating state of the BGR sub-circuit to the normal state, in response to the operating state of the BGR sub-circuit being the failure state.

2. The start-up circuit as claimed in claim 1, wherein the desired node is the slowest node of the BGR sub-circuit.

3. The start-up circuit as claimed in claim 1 or claim 2, wherein the output transistor is further configured to:
turn off while the operating state of the BGR sub-circuit is in the normal state; and
charge the desired node of the BGR sub-circuit in response to the operating state of the BGR sub-circuit being in the failure state.

4. The start-up circuit as claimed in any preceding claim, wherein the start-up capacitor is further configured to:
maintain a voltage differential between a top plate and a bottom plate of the start-up capacitor in response to the operating state of the BGR sub-circuit being the failure state, wherein the voltage differential facilitates activation of the output transistor.

5. The start-up circuit as claimed in claim 4, wherein in response to the operating state of the BGR sub-circuit being the normal state:
the top plate of the start-up capacitor is configured to be charged to VDD-VTH_{Diode}, wherein VDD is a power supply voltage and VTH_{Diode} is a threshold voltage of a diode connected between the power supply voltage and the top plate of the start-up capacitor;
the bottom plate of the start-up capacitor is configured to be charged to a voltage of the VBG node;
the start-up circuit is configured to be in an OFF state; and
the output transistor is configured to be turned off.

6. The start-up circuit as claimed in claim 4 or claim 5, wherein, in response to the operating state of the BGR sub-circuit being the failure state:
the output transistor is further configured to be switched on in response to the top plate of the start-up capacitor being charged to VDD-VTH_{Diode}- the voltage differential;
the bottom plate of the start-up capacitor is further configured to be charged to a difference between a voltage of the VBG node and the voltage differential; and
the start-up circuit is further configured to be turned on and change a condition of a memory node to be | VTHMOS | > VTH_{Diode}.

7. The start-up circuit as claimed in any of claims 4-6, wherein the bottom plate of the start-up capacitor is further configured to:
transition from 1.2V in response to the operating state of the BGR sub-circuit being the normal state, to VTH_{Diode} in response to the operating state of the BGR sub-circuit being the failure state, wherein the VTH_{Diode} varies between 0.5V and 0.7V.

8. The start-up circuit as claimed in any preceding claim, wherein the capacitor action-based start-up circuit further comprises:
an auxiliary network including an auxiliary transistor, the auxiliary network configured to control activation and deactivation of the start-up circuit; and
the auxiliary transistor configured to control a timing of the start-up circuit activation.

9. The start-up circuit of claim 8, wherein the capacitor action-based start-up circuit further comprises:
a failsafe mechanism including a failsafe transistor, the failsafe mechanism configured to protect the auxiliary network from false charging during one or more failure conditions while the BGR sub-circuit is powering up.

10. The start-up circuit as claimed in claim 8 or claim 9, wherein the auxiliary network is further configured to:
delay deactivation of the auxiliary transistor to facilitate a proper charging of the start-up capacitor to VDD-VTH_{Diode} voltage.

11. The start-up circuit as claimed in any preceding claim, wherein an operating state of the start-up circuit is determined by a voltage of the VBG node of the BGR sub-circuit.

12. The start-up circuit as claimed in any preceding claim, wherein, the start-up circuit comprises:
a diode, the diode configured to decrease a probability of reverse current;
an auxiliary transistor configured to be switched off in response to the start-up circuit being activated; and
a top plate of the start-up capacitor configured to charge to VDD - VTH_{Diode} a single time in response to the start-up circuit being activated.

13. A system, comprising:
a bandgap reference, BGR, sub-circuit; and
a capacitor action-based start-up circuit according to any preceding claim.

14. The system of claim 13, wherein the desired node is the slowest node of the BGR sub-circuit.

15. The system of claim 13 or claim 14, wherein the output transistor is further configured to:
turn off while the operating state of the BGR sub-circuit is in the normal state; and
charge the desired node of the BGR sub-circuit in response to the operating state of the BGR sub-circuit being in the failure state.
